# DEMANDE DE BREVET EUROPEEN

(11) **EP 0 933 801 A1**
(43) Date de publication de la demande: **04.08.1999**
(21) Numéro de dépôt: 99410006.3
(22) Date de dépôt: 29.01.1999
(51) Int. Cl.: H01L 21/205, H01L 21/20, C30B 29/06, C30B 25/18, H01L 21/285, H01L 29/417, H01L 21/265

(54) **Procédé de dépôt d'une région de silicium monocristallin**

(30) Priorité: 30.01.1998 FR 9801313
(71) Demandeur: STMicroelectronics S.A., 94250 Gentilly (FR); FRANCE TELECOM, 75015 Paris (FR)
(72) Inventeur: Gris, Yvon, 38210 Tullins (FR); Troillard, Germaine, 38660 Le Touvet (FR); Mourier, Jocelyne, 38120 Saint Egreve (FR)
(74) Mandataire: de Beaumont, Michel

(57) **Abrégé**

L'invention concerne un procédé de dépôt d'une couche de silicium sur un substrat de silicium monocristallin (11), de sorte que cette couche de silicium soit monocristalline, mais d'orientation différente de celle du substrat, comprenant les étapes consistant à délimiter une fenêtre sur le substrat ; créer à l'intérieur de la fenêtre des défauts interstitiels (14) dans une proportion atomique inférieure à un sur cent ; et effectuer un dépôt de silicium (15') dans des conditions correspondant généralement à celles d'un dépôt épitaxial, mais à une température inférieure à 900°C.

## Description

La présente invention concerne de façon générale la fabrication de dispositifs semiconducteurs.

Dans de nombreux procédés de fabrication de composants semiconducteurs, on est amené à déposer du silicium sur un substrat de silicium monocristallin, ou sur une zone de ce substrat. Plusieurs techniques sont couramment utilisées.

Un premier type de dépôt dit épitaxial, réalisé sous atmosphère réductrice, permet que la structure cristallographique de la couche déposée soit dans la continuité de celle du substrat. Ces techniques imposent un dépôt à haute température, typiquement comprise entre 1000 et 1200°C pour un dépôt sous pression atmosphérique et entre 900 et 1100°C sous pression réduite. L'atmosphère réductrice est obtenue en utilisant un mélange de gaz réactifs dans de l'hydrogène (H₂).

On connaît également des techniques, telles que le dépôt chimique en phase vapeur (CVD), qui permettent des dépôts de silicium à basse température (500 à 700°C). Avec ces techniques, le silicium déposé est sous forme polycristalline, ou éventuellement amorphe. Plus précisément, la taille des grains de silicium polycristallin diminue avec la température. A basse pression et à 550°C, le silicium déposé est sous forme amorphe.

Dans de nombreux cas, en fin de processus de fabrication d'un circuit intégré, on veut déposer du silicium sur une portion d'un substrat de silicium monocristallin pour former soit une source de dopage du substrat, soit une reprise de contact entre une couche sous-jacente et l'environnement externe, soit encore pour assurer simultanément ces deux fonctions. Il est alors essentiel que les températures mises en oeuvre ne dépassent pas une valeur de l'ordre de 600°C pour ne pas provoquer de diffusions indésirables de dopants.

Un objet de la présente invention est de proposer un procédé de dépôt à basse température (inférieure à 750°C) de silicium sur un substrat de silicium monocristallin, tel que le silicium déposé ait une structure monocristalline.

Un autre objet de la présente invention est de proposer un procédé de dépôt à basse température de silicium sur un substrat de silicium monocristallin, tel que le silicium déposé ait une structure monocristalline d'axes cristallographiques distincts de ceux du substrat.

Un autre objet de la présente invention est de proposer une application particulière de ce procédé à la fabrication d'émetteurs de transistors bipolaires.

Pour atteindre ces objets, la présente invention prévoit un procédé de dépôt d'une couche de silicium sur un substrat de silicium monocristallin, de sorte que ladite couche de silicium soit monocristalline, mais d'orientation différente de celle du substrat, comprenant les étapes consistant à délimiter une fenêtre sur ledit substrat ; créer à l'intérieur de la fenêtre des défauts interstitiels dans une proportion atomique inférieure à un sur cent ; et effectuer un dépôt de silicium dans des conditions correspondant généralement à celles d'un dépôt épitaxial, mais à une température inférieure à 900°C.

Selon un mode de réalisation de la présente invention, la température de dépôt est comprise entre 600 et 700°C.

Selon un mode de réalisation de la présente invention, l'étape de création de défauts comprend une étape d'implantation.

Selon un mode de réalisation de la présente invention, l'implantation est réalisée à travers une couche d'oxyde de silicium d'une épaisseur inférieure à 10 nm et cette implantation est suivie d'une étape d'enlèvement de la couche d'oxyde de silicium.

Selon un mode de réalisation de la présente invention, l'implantation est une implantation d'un élément électriquement neutre.

Selon un mode de réalisation de la présente invention, l'implantation est une implantation d'un élément choisi dans le groupe comprenant le fluor, le silicium, le germanium, le bore, l'indium, le phosphore, l'arsenic et l'antimoine.

Selon un mode de réalisation de la présente invention, l'implantation d'un élément électriquement neutre est une implantation de fluor à 12 keV, à 10¹³ at./cm².

Selon un mode de réalisation de la présente invention, l'ouverture de la fenêtre est réduite à une largeur inférieure à 5 µm, de préférence, de l'ordre de 0,35 µm.

Selon un mode de réalisation de la présente invention, la réduction de la largeur de l'ouverture de la fenêtre est réalisée par des espaceurs composites.

Selon un mode de réalisation de la présente invention, les espaceurs composites sont constitués de régions en nitrure de silicium, et d'espaceurs en silicium polycristallin.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A, 1B et 1C illustrent schématiquement des étapes successives d'un procédé selon l'invention ;
les figures 2A, 2B et 2C illustrent un mode de réalisation de certaines étapes du procédé selon l'invention ; et
les figures 3A à 3D représentent un exemple d'application du procédé selon l'invention à la formation de l'émetteur d'un transistor bipolaire.

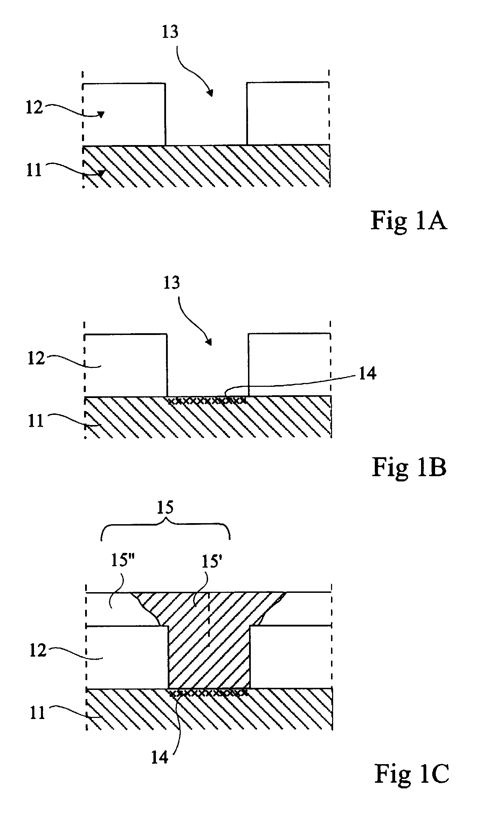

Comme le représente la figure 1A, on considère un substrat 11 de silicium monocristallin, au-dessus duquel est formée une couche 12 munie d'une fenêtre 13, d'une largeur inférieure à 5 µm de large et, de préférence, inférieure à 1 µm. L'objet de la présente invention est de développer une zone de silicium monocristallin à partir de la surface apparente du substrat 11 dans l'ouverture 13.

Comme le représente la figure lB, on pratique à la surface de la région de la couche 11 découverte par la fenêtre 13, un traitement propre à créer dans la région 14 découverte des défauts interstitiels dans le réseau cristallin qui est ainsi légèrement déformé localement. Le traitement est pratiqué de façon à créer des défauts dans une proportion de l'ordre d'un atome sur cent, sur une profondeur inférieure à 5 nm. Une telle dose est trop faible pour amorphiser le silicium qui demeure monocristallin. En particulier, on peut utiliser toute gravure type plasma ou RIE, dans laquelle des ions sont dirigés vers la surface pour créer une gravure chimique anisotrope. Toute implantation volontaire d'ions ou d'atomes neutres créera mécaniquement des défauts interstitiels. Selon l'invention, ces défauts doivent, de préférence être localisés en surface. Pour cette raison, on préfère aujourd'hui utiliser des particules chargées à des atomes neutres. Les équipements les plus performants sont les implanteurs utilisés en micro-électronique car ils permettent un parfait contrôle du flux et de l'énergie des ions implantés. Suivant la valence de l'atome implanté, en plus de l'effet mécanique - création de défauts interstitiels - aura lieu un second effet électrique quand l'atome ajouté se substituera à un atome de silicium existant. En pratique, on effectuera des implantations de bore (¹¹B), d'indium (¹¹⁴In) pour effectuer un dopage de type P, des implantations de phosphore (³¹P), d'arsenic (⁷⁵As) ou d'antimoine (¹²²Sb) pour un dopage de type N, ou encore du silicium (²⁸Si), du germanium (⁷³Ge) ou du fluor (¹⁹F) pour rester neutre électriquement. Tout autre atome massif est utilisable.

Comme cela est représenté à la figure 1C, immédiatement après ce traitement, et notamment sans prévoir d'étape de recuit, on réalise le dépôt d'une couche supérieure 15 dans des conditions proches d'un dépôt épitaxial, c'est-à-dire sous atmosphère réductrice mais à une température inférieure à la température généralement utilisée pendant un dépôt épitaxial. La température du dépôt selon l'invention est typiquement dans une plage comprise entre 600 et 700°C, par exemple, de 630°C sous une pression réduite de 0,1.10⁵ Pa (80 torr), le gaz réactif étant du silane (SiH₄).

Dans l'ouverture de la fenêtre et sensiblement à la verticale de celle-ci, la couche 15, désignée par la référence 15', hachurée en figure 1C, prend une structure monocristalline, comme le substrat 11, mais selon des axes cristallographiques différents de ceux du substrat 11. En dehors de la fenêtre, sensiblement au-dessus de la couche 12, la couche 15, désignée par la référence 15", prend de façon classique une structure polycristalline, ou éventuellement amorphe.

On obtient donc selon l'invention la mise en contact d'une zone d'un substrat monocristallin 11 avec une région 15' de silicium monocristallin d'axes cristallographiques différents de ceux du substrat 11.

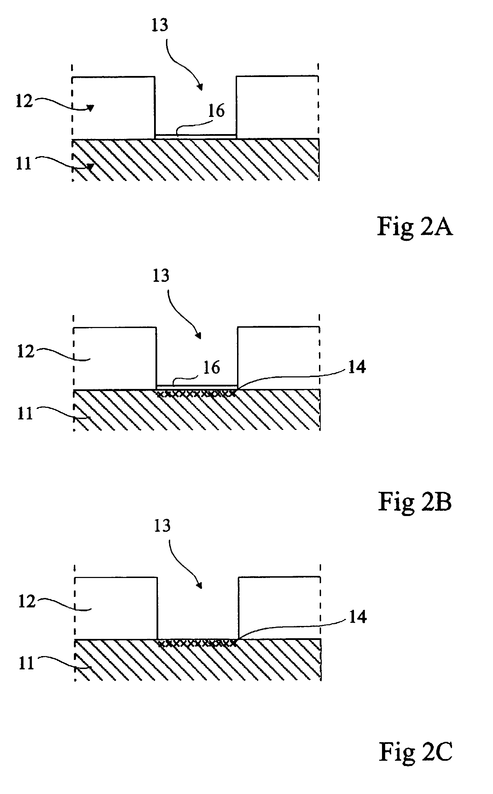

Les figures 2A à 2C illustrent un mode de réalisation particulier de traitement de création de défauts interstitiels. On part d'un substrat 11 de silicium monocristallin, au-dessus duquel est formée une couche 12 munie d'une fenêtre 13. La surface apparente du substrat 11 dans la fenêtre 13 est recouverte d'une couche 16 d'oxyde de silicium. Cette couche d'oxyde 16, très mince, d'une épaisseur inférieure à 10 nm, est soit un oxyde natif, soit une couche d'oxyde thermique formée volontairement. Cette couche d'oxyde sacrificielle a un rôle important de nettoyage et de restructuration de la surface du silicium monocristallin.

Comme l'illustre la figure 2B, on réalise alors une implantation 14 à faible dose à travers la couche d'oxyde 16. En dehors de la fenêtre, cette implantation est masquée par la couche 12.

A l'étape suivante représentée en figure 2C, la couche d'oxyde 16 est éliminée par gravure humide. La structure du substrat est alors identique à celle déjà décrite en relation avec la figure 1B.

Ensuite, sans réaliser au préalable de recuit, on effectue le dépôt de silicium selon l'invention. On obtient ainsi la mise en contact directe d'une zone d'un substrat monocristallin 11 avec une région 15' de silicium monocristallin d'axes cristallographiques différents de ceux du substrat 11, comme cela a été décrit précédemment en relation avec la figure 1C.

Le corps implanté 14 est caractérisé par sa masse, son énergie, et le cas échéant son effet électrique. L'implantation est réalisée à faible énergie et faible concentration, de façon à créer une densité de défauts, par exemple, de l'ordre de 10¹⁹ at./cm³ sur une profondeur de l'ordre de 10 nm. A titre d'exemple, la demanderesse a réalisé avec succès des implantations de silicium, de fluor et de bore (¹¹B). Par exemple, une implantation de fluor a été réalisée à travers une couche d'oxyde de 5 nm, sous une énergie de 10 keV et à une densité de 4.10¹² at./cm².

La couche 12 représentée en figures 1A à 1C et 2A à 2C, peut être constituée de tout matériau couramment utilisé dans le domaine de la fabrication des circuits intégrés, par exemple oxyde de silicium (SiO₂), nitrure de silicium (Si₃N₄). Il pourra également s'agir d'un empilement de couches comprenant, par exemple, une ou plusieurs couches isolantes et, éventuellement, une ou plusieurs couches conductrices.

On va décrire ci-après, uniquement à titre d'exemple, et sans que cela constitue une limitation de la présente invention pour laquelle l'homme de l'art pourra prévoir de nombreuses autres applications, une application particulière de la présente invention à la formation d'un émetteur de transistor bipolaire.

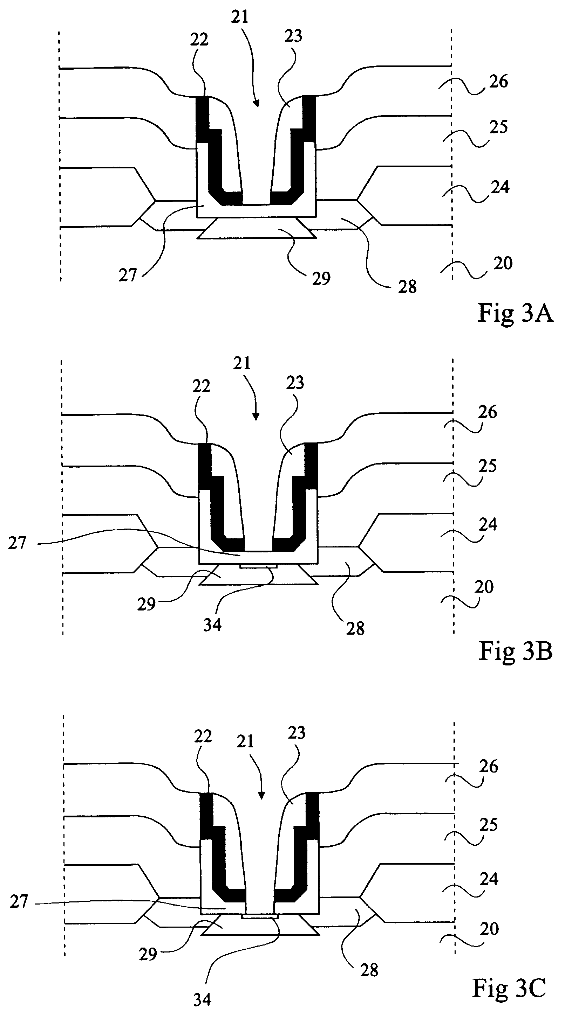

Les figures 3A à 3D illustrent des étapes de formation d'un émetteur de transistor bipolaire de type NPN dans une technologie BICMOS submicronique développée par la demanderesse.

La figure 3A représente un transistor bipolaire avant la formation de l'émetteur, tel que décrit dans la demande de brevet français N° 96/14412 de la demanderesse. Avant formation de l'émetteur, la structure comporte notamment :
une couche 20 épitaxiale de type N ;
une couche 24 d'oxyde épais délimitant une zone de base ;
une couche 25 de contact de base, en silicium polycristallin dopé de type P, par exemple au bore ; et
une couche 26 d'oxyde d'encapsulation.

Une ouverture 21 est formée dans les couches 25 et 26 sensiblement au centre de la fenêtre définie par l'oxyde épais 24.

Un oxyde thermique 27 recouvre la paroi de silicium polycristallin 25 et le fond de silicium 28 de l'ouverture 21. Une région de base extrinsèque 28 ayant par exemple une profondeur de jonction de l'ordre de 100 nm résulte d'une diffusion du dopant (par exemple, du bore) contenu dans la couche de silicium polycristallin 25. Une région de base intrinsèque 29 résulte d'une implantation (par exemple, de type P) délimitée par l'ouverture 21. Cette base intrinsèque est de préférence implantée au bore à faible énergie (par exemple, 2.10¹³ atomes/cm² sous 5 keV).

Ensuite, les parois latérales de l'ouverture ont été munies d'espaceurs composites formés de régions 22 de nitrure de silicium, et d'espaceurs 23 de silicium polycristallin. L'ensemble du nitrure 22 et des espaceurs 23 définit donc une ouverture plus petite que l'ouverture initialement formée dans les couches 25 et 26 pour la définition de la base intrinsèque 28. Cette ouverture plus petite est l'ouverture d'émetteur et a une largeur inférieure à 5 µm, de préférence de l'ordre de 0,35 µm. De préférence, les espaceurs 23 résultent d'une gravure ionique réactive de silicium polycristallin et l'ouverture dans le fond de la couche de nitrure 22 résulte d'une gravure chimique humide. Il en résulte que la surface de la zone de base 29 est exempte de défauts qui pourraient résulter d'une gravure plasma de la couche 23.

A partir de cette structure, on veut former une région de contact d'émetteur servant également de source de dopage d'émetteur par diffusion dans la région de base intrinsèque sous-jacente 29. Dans la demande de brevet susmentionnée, cela est effectué par dépôt CVD de silicium polycristallin.

Selon l'invention, comme l'illustre la figure 3B, on réalise à travers la couche 27 d'oxyde une implantation 34 à la surface de la région de base intrinsèque 29. Cette implantation 34 est réalisée pour créer des défauts interstitiels, de préférence, sur une profondeur de l'ordre de 10 nm, avec un corps électriquement neutre, afin de ne pas affecter le dopage de la fine base intrinsèque, par exemple, du fluor, à 12 keV, à 10¹³ at./cm², à travers une couche d'oxyde de 5 nm.

A l'étape suivante, représentée à la figure 3C, c'est-à-dire sans étape de recuit intermédiaire, on nettoie soigneusement, par exemple dans un bain d'acide fluorhydrique dilué, la région de la couche d'oxyde 27 apparente au fond de l'ouverture.

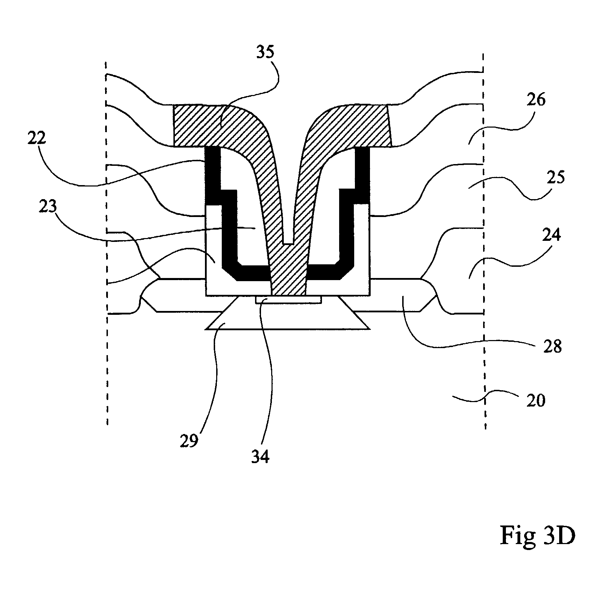

A l'étape suivante représentée à la figure 3D, on dépose selon l'invention une couche 35 de silicium. Ce dépôt est réalisé dans les conditions généralement utilisées pour un dépôt épitaxial en atmosphère réductrice, par exemple, à partir d'un mélange d'hydrogène et de silane (SiH₄), mais à une température de l'ordre de 650°C, donc inférieure à la température usuelle d'une épitaxie. La couche 35 ainsi formée présentera dans l'ouverture, et sensiblement à la verticale de celle-ci, une structure monocristalline, mais d'axes différents de ceux de la structure monocristalline de la base intrinsèque 29. En outre, comme le dépôt est réalisé dans un réacteur d'épitaxie, on peut simultanément effectuer un dopage important (par exemple, de type N) de cette couche 35 (par exemple, à partir d'arsine AsH₃).

L'application du procédé selon la présente invention conduit à une couche 35 de contact d'émetteur monocristalline sur une couche de base monocristalline. L'interface entre ces couches d'axes cristallographiques différents présente donc un unique joint de grain.

Des mesures effectuées par microscopie à transmission permettant de visualiser les atomes, et donc la structure cristalline, ont montré que la zone perturbée au niveau du joint de grain s'étendait sur une épaisseur de moins de 3 à 5 couches atomiques.

Un avantage de la présente invention est qu'un émetteur monocristallin est parfaitement reproductible et présente des caractéristiques bien déterminées, au contraire d'un émetteur polycristallin classique. En effet, deux structures polycristallines ne sont jamais parfaitement identiques, ce qui conduit à des variations de caractéristiques de fonctionnement d'un transistor à l'autre.

En présence d'une interface incohérente classique entre une région de base monocristalline et une couche de contact d'émetteur polycristalline, apparaissaient des phénomènes de "pompage de dopants", c'est-à-dire, une concentration locale indésirable des dopants de la couche sous-jacente, ce qui modifie le dopage de la région de base. L'interface cohérente du procédé selon la présente invention élimine ce problème.

Les interfaces incohérentes antérieures généraient des bruits aléatoires du fait du caractère incontrôlable de la structure des joints de grain incohérents associés. Ces bruits n'apparaissent plus dans le cas de l'interface cohérente du procédé selon la présente invention.

Dans un émetteur classique, c'est-à-dire polycristallin, il se produit, lors du fonctionnement du transistor dont cet émetteur fait partie, des recombinaisons de porteurs minoritaires (des trous dans le cas d'un transistor NPN) qui diminuent le gain du dispositif. Ces recombinaisons ne sont plus possibles, ou sont réduites, dans le cas de l'émetteur monocristallin selon la présente invention dans lequel les recombinaisons sont localisées au niveau du joint de grain et de la métallisation formée sur la couche de silicium monocristallin de reprise de contact d'émetteur. Il en résulte que les caractéristiques de courant de base selon l'invention sont améliorées, et donc que le gain du transistor associé est augmenté.

Les interfaces incohérentes augmentaient la résistance d'émetteur, ce qui réduisait le courant maximum possible dans le transistor associé et créait des éléments passifs parasites.

Un autre avantage de la présente invention est de rendre le courant de base relativement insensible à la surface de l'interface émetteur-base et relativement insensible au volume de l'émetteur, le seul élément recombinant des porteurs minoritaires dans ce volume étant les porteurs majoritaires et non plus les joints de grain. Ainsi, suivant les conditions de dopage, le courant de base dépendra principalement du seul élément recombinant restant : la surface du contact métallique.

Un autre avantage de la présente invention est que le courant injecté par l'émetteur est toujours proportionnel à la surface émetteur-base. En conséquence, le gain du transistor associé peut-être ajusté en fonction du rapport entre la surface de contact et la surface émetteur-base.

La présente invention est susceptible de diverses variantes dans sa réalisation et ses applications. On pourra notamment l'appliquer à des structures de circuits intégrés. En outre, elle permet de définir un domaine parfaitement délimité, en haut et sur les côtés par des diélectriques et en bas par une barrière de potentiel. Les propriétés de cette "boîte" et de l'interface monoatomique sous-jacent sont utilisables dans beaucoup d'autres domaines que le transistor bipolaire. En particulier, ce principe est applicable à des détecteurs, l'interface étant très propre, à la fabrication de diodes rapides, à la modification de structures de bandes d'énergie dans un domaine limité en ramenant à quelques nanomètres l'épaisseur du dépôt de la couche supérieure (15 ou 35 dans les exemples ci-dessus). Grâce à la présente invention des superréseaux uniquement en silicium deviennent également réalisables.

## Revendications

1. Procédé de dépôt d'une couche de silicium sur un substrat de silicium monocristallin (11), de sorte que ladite couche de silicium soit monocristalline, mais d'orientation différente de celle du substrat, caractérisé en ce qu'il comprend les étapes suivantes :
délimiter une fenêtre (13) sur ledit substrat ;
créer à l'intérieur de la fenêtre des défauts interstitiels (14) dans une proportion atomique inférieure à un sur cent ; et
effectuer un dépôt de silicium (15') dans des conditions correspondant généralement à celles d'un dépôt épitaxial, mais à une température inférieure à 900°C.

2. Procédé selon la revendication 1, caractérisé en ce que la température de dépôt est comprise entre 600 et 700°C.

3. Procédé selon la revendication 2, caractérisé en ce que l'étape de création de défauts comprend une étape d'implantation.

4. Procédé selon la revendication 3, caractérisé en ce que ladite implantation est réalisée à travers une couche d'oxyde de silicium (16) d'une épaisseur inférieure à 10 nm et en ce que cette implantation est suivie d'une étape d'enlèvement de la couche d'oxyde de silicium.

5. Procédé selon les revendications 3 ou 4, caractérisé en ce que ladite implantation est une implantation d'un élément électriquement neutre.

6. Procédé selon la revendication 3, caractérisé en ce que l'implantation est une implantation d'un élément choisi dans le groupe comprenant le fluor, le silicium, le germanium, le bore, l'indium, le phosphore, l'arsenic et l'antimoine.

7. Procédé selon la revendication 6, caractérisé en ce que ladite implantation d'un élément électriquement neutre est une implantation de fluor à 12 keV, à 10¹³ at./cm².

8. Procédé selon la revendication 1, caractérisé en ce que l'ouverture de la fenêtre est réduite à une largeur inférieure à 5 µm, de préférence, de l'ordre de 0,35 µm.

9. Procédé selon la revendication 8, caractérisé en ce que la réduction de la largeur de l'ouverture de la fenêtre est réalisée par des espaceurs composites.

10. Procédé selon la revendication 9, caractérisé en ce que les espaceurs composites sont constitués de régions (22) en nitrure de silicium, et d'espaceurs (23) en silicium polycristallin.
